# EUROPEAN PATENT APPLICATION

(11) **EP 3 678 177 A1**
(43) Date of publication of application: **08.07.2020**
(21) Application number: 19150608.8
(22) Date of filing: 07.01.2019
(51) Int. Cl.: H01L 25/075, H01L 33/62, H01L 33/64, H01L 33/50

(54) **FLEXIBLE LED STRUCTURE AND ASSEMBLY THEREOF**

(71) Applicant: Mutual-Pak Technology Co., Ltd., 320 Taoyuan County (TW); HSN Materials Co., Ltd, 110 Taipei City (TW)
(72) Inventor: LEE, YI-JHEN, 551 Nantou County (TW)
(74) Representative: 2K Patentanwälte Blasberg Kewitz & Reichel

(57) **Abstract**

The present invention provides a flexible LED structure, comprising: a flexible substrate composed of a metal layer and a ceramic insulating layer, wherein the metal layer forms as a core of the flexible substrate and is coated with the ceramic insulating layer, and the flexible substrate is provided with a positive electrode and a negative electrode at one end of the flexible substrate or at two ends of the flexible substrate respectively; a plurality of LED chips provided on the flexible substrate; and, a plurality of electrical conduction units arranged between the LED chips and electrically connected to the LED chips, the positive electrode, and the negative electrode. The flexible LED structure and assembly thereof of the present invention has the advantages of bendability, high heat dissipation efficiency, and 360° illumination, which can be applied to a greater variety of lamps and take a wider range of shapes than conventionally allowed in the lighting industry, thereby contributing to the popularization of LED lamps, which are generally recognized as environmentally friendly.

## Description

### BACKGROUND OF THE INVENTION

### 1. Technical Field

The present invention relates to a light-emitting diode (LED) structure and an assembly thereof. More particularly, the invention relates to an LED structure that is composed of a core metal layer coated with a ceramic insulating layer and that therefore exhibits flexibility as well as rigidity and high efficiency in heat dissipation, and to an assembly of such LED structures.

### 2. Description of Related Art

Modern society's pursuit of high performance has extended rapidly to the field of illumination. In consequence, the conventional incandescent lightbulbs, which are well known for their high power consumption and low brightness, can no longer satisfy the needs of modern life. The relatively short service lives of the conventional lightbulbs have also placed a heavy burden on the environment. In light of the above, and with the rapid advancement of lighting technology, LED-based lighting devices were developed and are now in extensive use thanks to their low power consumption, high brightness, and long service lives. However, an LED lamp has a limited lighting angle, typically 120° or so, meaning an LED lamp can provide high-brightness illumination only within a small angular range in which a direct view of its LED chip(s) is obtainable; light projected outside that range dims drastically. As far as spatial lighting is concerned, therefore, the application of LED lamps is subject to restrictions.

Recently, LED filaments were devised to address the lighting angle issue of LED lamps while preserving the advantages of those lamps. More specifically, an elongated base is provided thereon with a plurality of series-connected LED chips, or dies, to form a light-emitting filament, and a lampshade is mounted around the filament in order for the filament to provide 360° illumination similar to that of a conventional tungsten-filament lightbulb. LED filaments can be generally divided by the base material into rigid filaments and pliable ones. Some conventional examples of rigid filament materials are sapphire, ceramic, glass, and metal. Pliable filaments, on the other hand, are typically made of copper foil-coated polymer films. For example, bismaleimide-triazine resin, polyethylene resin, or polyimide resin.

### BRIEF SUMMARY OF THE INVENTION

Rigid LED filaments using a sapphire or ceramic base incur high material cost. Pliable LED filaments, though advantageously flexible, include resin-based components that tend to lower heat dissipation efficiency by being ineffective in dissipating the heat generated by the high-power elements. While the LED chips on a pliable LED filament are small, failure to dissipate localized heat effectively to the outside will raise the temperature of the entire filament, thus lowering the light emission efficiency and brightness of the LEDs, if not ending the theoretical service life of the affected LED lamp prematurely.

In view of the above, it is imperative for the lighting industry to develop an LED structure that can dissipate heat as efficiently as rigid structures, has the flexibility of pliable structures, and features all-around distribution of light, the objective being to render LED lamps more versatile in the lighting industry.

The objective of the present invention is to provide a flexible light-emitting diode (LED) structure, comprising a flexible substrate, a plurality of LED chips, and a plurality of electrical conduction units. The flexible substrate is composed of a metal layer and a ceramic insulating layer, wherein the metal layer forms as a core of the flexible substrate and is coated with the ceramic insulating layer, and the flexible substrate is provided with a positive electrode and a negative electrode at one end of the flexible substrate or at two ends of the flexible substrate respectively. The plurality of LED chips is provided on the flexible substrate. The plurality of electrical conduction units is arranged between the LED chips and electrically connected to the LED chips, the positive electrode, and the negative electrode.

In a preferred embodiment, the flexible LED structure further includes a phosphor layer, and the phosphor layer at least partially covers the LED chips and the electrical conduction units on the flexible substrate.

In a preferred embodiment, the metal layer has a plurality of through holes, and each said through hole has an inner circumference wall coated with the ceramic insulating layer.

In a preferred embodiment, the ceramic insulating layer has a thickness of 10 µm∼400 µm.

In a preferred embodiment, the positive electrode and the negative electrode are respectively formed, by a metal plating process, at two ends of a side of the flexible substrate that is provided with the LED chips, and the electrodes are parallel to the LED chips.

In a preferred embodiment, the LED chips are horizontal chips or flip chips.

In a preferred embodiment, the flexible LED structure is bent into a U-shaped structure such that: a side of the flexible substrate that is not provided with the LED chips forms an inner side of the U-shaped structure, a side of the flexible substrate that is provided with the LED chips forms an outer side of the U-shaped structure, and the positive electrode and the negative electrode are respectively located at end points of the U-shaped structure.

Another objective of the present invention is to provide a flexible light-emitting diode (LED) structure assembly, comprising a plurality of the above flexible LED structures, wherein the flexible LED structures are tightly attached to each other via sides of the flexible substrates that are not provided with the LED chips.

The present invention provides a flexible LED structure and an assembly thereof that are advantageously bendable, efficient in heat dissipation, and capable of 360° illumination. Therefore, the present invention is applicable to a greater variety of lamps and can take a wider range of shapes than conventionally allowed in the lighting industry, thereby encouraging more extensive use of LED lamps, which are generally recognized as eco-friendly.

### BRIEF DESCRIPTION OF THE SEVERAL VIEWS OF THE DRAWINGS

FIG. 1 shows a sectional view of the flexible LED structure according to the first embodiment of the present invention.
FIG. 2 shows a top view of the flexible LED structure according to the first embodiment of the present invention.
FIG. 3 shows a sectional view of the flexible LED structure according to the second embodiment of the present invention.
FIG. 4 shows a top view of the flexible LED structure according to the second embodiment of the present invention.
FIG. 5 shows a sectional view of the flexible LED structure according to the third embodiment of the present invention.
FIG. 6 shows a top view of the flexible LED structure according to the third embodiment of the present invention.
FIG. 7 shows a sectional view of the flexible LED structure according to the fourth embodiment of the present invention.
FIG. 8 shows a sectional view of the flexible LED structure assembly according to the fifth embodiment of the present invention.

### DETAILED DESCRIPTION OF THE INVENTION

The details and technical solution of the present invention are hereunder described with reference to accompanying drawings. For illustrative sake, the accompanying drawings are not drawn to scale. The accompanying drawings and the scale thereof are restrictive of the present invention.

Throughout the whole document, the term "comprises or includes" and/or "comprising or including" used in the document means that one or more other components, steps, operations, and/or the existence or addition of elements are not excluded in addition to the described components, steps, operations and/or elements. The terms "about or approximately" or "substantially" are intended to have meanings close to numerical values or ranges specified with an allowable error and intended to prevent accurate or absolute numerical values disclosed for understanding of the present invention from being illegally or unfairly used by any unconscionable third party. The terms "a" and "an" refer to one or to more than one (i.e., to at least one) of the grammatical object of the article.

The following paragraphs describe a preferred embodiment of the present invention.

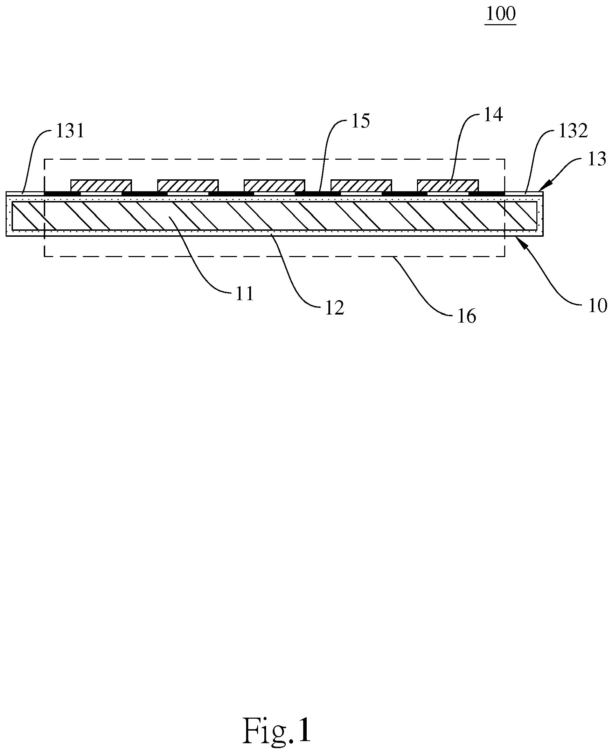

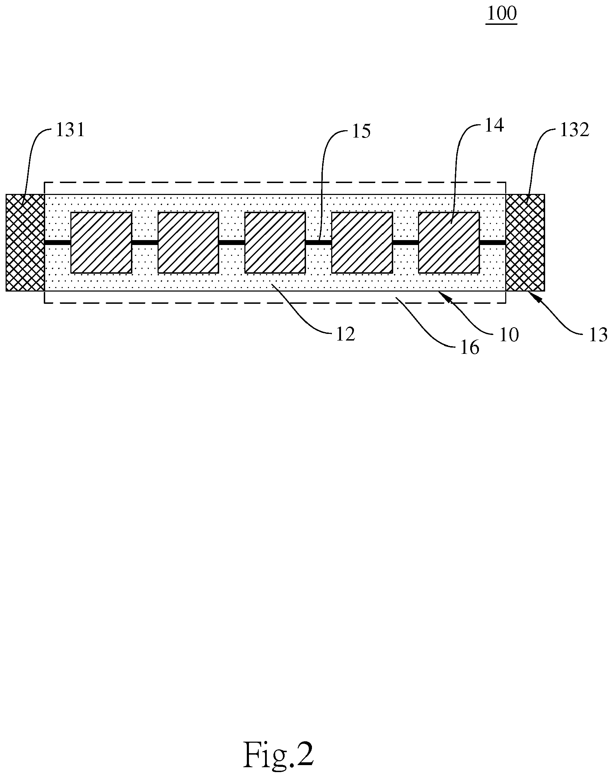

Please refer to FIG. 1 and FIG. 2, which are respectively a sectional view and a top view of the flexible LED structure 100 according to an embodiment of the present invention. The flexible LED structure 100 includes a flexible substrate 10, a plurality of LED chips 14, and a plurality of electrical conduction units 15. The flexible substrate 10 is composed of a metal layer 11 and a ceramic insulating layer 12. The metal layer 11 forms the core of the flexible substrate 10 and is coated with the ceramic insulating layer 12. The flexible substrate 10 is provided with a positive electrode 131 and a negative electrode 132 at one end, or respectively at two ends. The LED chips 14 are provided on the flexible substrate 10. The electrical conduction units 15 are arranged between the LED chips 14 and are electrically connected to the LED chips 14 and the positive and negative electrodes 131, 132.

As used herein, the terms "flexible" and "flexibility" refer to an object's ability to be bent or curved, i.e., pliable or pliability. In one embodiment, the flexible LED structure of the present invention is a linear structure. In another embodiment, the flexible LED structure of the present invention is a curved structure with a curvature. In yet another embodiment, the flexible LED structure of the present invention is a folded structure that has been bent through 180°. In still another embodiment, the flexible LED structure of the present invention is a spiral structure. The aforesaid flexible or inflexible configurations of the flexible LED structure of the present invention are provided by way of example only and are not intended to be restrictive of the flexible configuration of the flexible LED structure of the present invention.

As used herein, the term "phosphor layer 16/26/36" refers to a transparent gel-like substance in which phosphor powder is dispersed. The main functions of the phosphor layer are: (1) allowing the light emitted by the LED chips to change colors by passing through the phosphor layer, (2) allowing the phosphor powder to be excited by either the light emitted by the LED chips or an external light source so that the entire phosphor layer provides photoluminescence and serves as an indirect light source for the flexible LED structure, and (3) protecting the LED chips and the electrical conduction units, reducing oxidation, and thereby extending the service life of the flexible LED structure. Some examples of the transparent gel-like substance are phenol-formaldehyde resins, epoxy resins, silicones, polyurethane resins, unsaturated polyester resins, acrylic resins, polyolefins/thiols, and vinyl ether resins. Preferably, the transparent gel-like substance is an epoxy resin, silicone, methyl silicone resin, phenyl silicone resin, methyl phenyl silicone resin, or modified silicone resin; the present invention has no limitation in this regard. The phosphor layer may cover only the side of the flexile LED structure on which the LED chips are located (i.e., the die-bonded side), thereby providing single-sided encapsulation; or cover the die-bonded side and the two lateral sides of the die-bonded side, exposing only the non-die-bonded side and the electrodes, thereby providing three-sided encapsulation; or cover the flexible LED structure in its entirety, exposing only the electrodes and thereby providing four-sided encapsulation. In one preferred embodiment, the phosphor layer 16 at least partially covers the LED chips 14 and the electrical conduction units 15 on the flexible substrate 10.

As used herein, the term "metal layer 11/21/31" refers to any one selected from the group consisting of Al, Cu, Ag, Au, Ti, Pt, Zn, Ni, a combination of at least two of the foregoing metals, and an alloy of at least two of the foregoing metals; the present invention has no limitation in this regard. In one preferred embodiment, the metal layer 11 is aluminum, an aluminum alloy, copper, or a copper alloy. For example, the copper alloy may be, but is not limited to, a copper-zinc alloy, a copper-tin alloy, a copper-aluminum alloy, a copper-silicon alloy, or a copper-nickel alloy; and the aluminum alloy may be, but is not limited to, an aluminum-silicon alloy, an aluminum-magnesium-silicon alloy, an aluminum-copper alloy, an aluminum-magnesium alloy, an aluminum-manganese alloy, an aluminum-zinc alloy, or an aluminum-lithium alloy.

As used herein, the term "electrodes 13/23/33" refers to a positive electrode 131/231/331 and a negative electrode 132/232/332. The electrodes 13/23/33 may be located at one end of the flexible substrate 10/20/30 or at two ends of the flexible substrate respectively and are electrically connected to the LED chips 14/24/34 through the electrical conduction units 15/25/35. The electrodes 13/23/33 may be any conventional electrode material. For example. The electrode material may be, but not limited to, AlCu, TiN, TaN, WN, Au, Ag, Ti, Ta, W, Cu, Pt, Pd and an alloy of at least two of the foregoing metals; the present invention has no limitation in this regard. In one preferred embodiment, the electrodes 13 are respectively formed, by a metal plating method, at two ends of the flexible substrate 10 and are parallel to the LED chips 14, wherein the metal plating method includes methods conventionally used to form metal on ceramic, such as electroplating, chemical plating, and immersion plating. A conventional LED structure, by contrast, uses adhesive to secure the positive and negative electrodes to two ends of the LED base material respectively, wherein the adhesive is typically resin-based adhesive (e.g., an epoxy resin), which has low thermal conductivity when cured and hence prevents effective heat dissipation from the base material while the LED structure is supplied with electricity and emitting light. Even if the conventional LED structure uses a material with high thermal conductivity, the low thermal conductivity of the adhesive will hinder heat dissipation, thus lowering the heat dissipation efficiency of the entire LED structure. The positive and negative electrodes in the present invention (i.e., metal with high thermal conductivity) are formed by a metal plating method and are therefore directly coupled to the ceramic insulating layer (i.e., a ceramic material with high thermal conductivity) without using adhesive, which generally has low thermal conductivity. Consequently, the LED structure of the present invention can, as a whole, dissipate heat far more efficiently than its conventional counterparts.

As used herein, the term "ceramic insulating layer 12/22/32" refers to a conventional ceramic material, which includes various metal oxides, carbides, nitrides, borides, silicides, and combinations of the above. For example, the ceramic insulating layer may be, but is not limited to, SiC, Si₃N₄, AlN, Al₂O₃, TiC, TiB₂ or B₄C; the present invention has no limitation in this regard. Preferably, the ceramic insulating layer is Al₂O₃, Si₃N₄, or AlN because of the excellent heat conductivity and small thermal expansion coefficient. The ceramic insulating layer 12/22/32 is formed by a conventional ceramic-metal composite forming method, including but not limited to coating, anodizing, micro-arc oxidation, plasma electrolytic oxidation, magnetron sputtering, and a sol-gel process. In one embodiment, the ceramic insulating layer 12/22/32 has a thickness of 10 µm∼400 µm, preferably 20 µm∼200 µm, more preferably 30 µm∼50 µm. For example, the thickness of the ceramic insulating layer 12/22/32 may be 10 µm, 20 µm, 30 µm, 40 µm, 50 µm, 60 µm, 70 µm, 80 µm, 90 µm, 100 µm, 120 µm, 130 µm, 140 µm, 150 µm, 160 µm, 170 µm, 180 µm, 190 µm, 200 µm, 225 µm, 250 µm, 275 µm, 300 µm, 325 µm, 350 µm, 375 µm or 400 µm. A ceramic insulating layer whose thickness falls into any of the foregoing ranges is not prone to embrittlement but flexible and can withstand the stamping force applied during the substrate machining process. The ceramic insulating layer may also be rendered reflective by a mirror surface finish.

As used herein, the term "LED chip 14/24/34" refers to an LED chip, or die, of any type that is electrically connected to the electrodes 13/23/33 through the electrical conduction units 15/25/35. In one preferred embodiment, the LED chips 14/24/34 may be horizontal chip or flip chip.

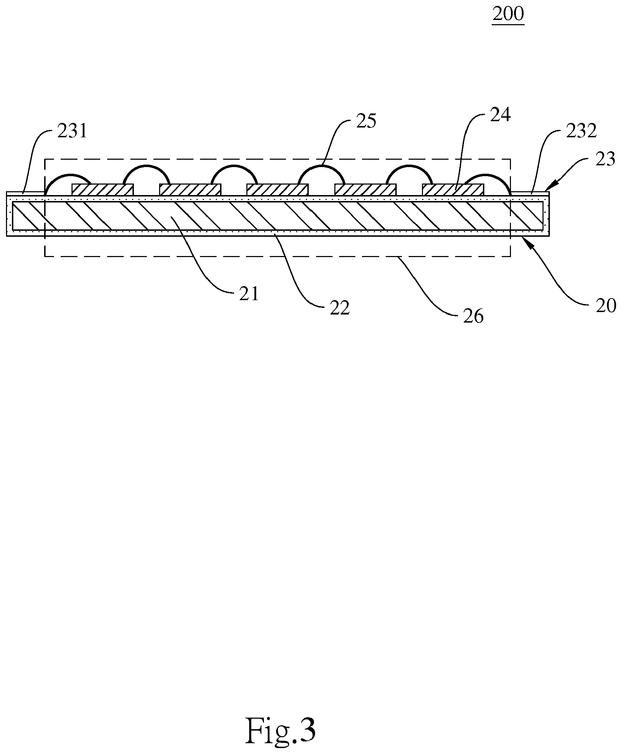

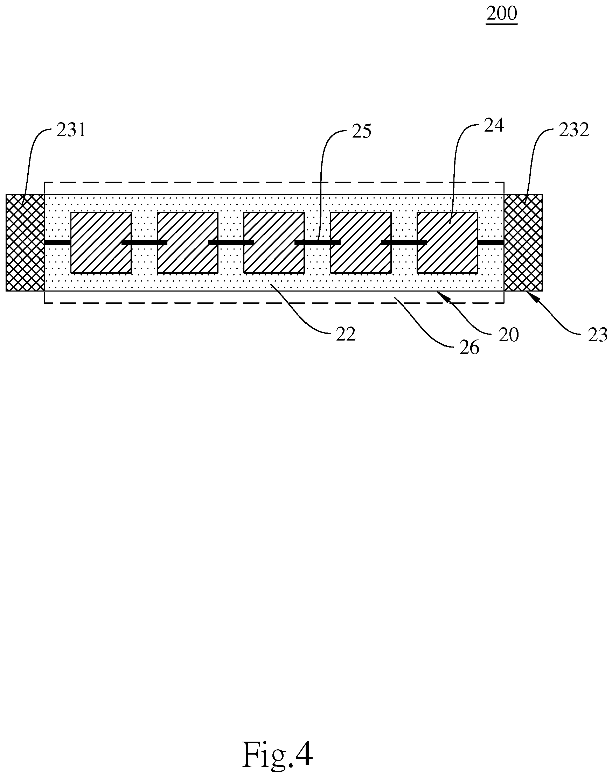

As used herein, the term "electrical conduction unit 15/25/35" refers to any material or element that allows passage of electric current, provides electrical conduction, and electrically connects the plurality of LED chip 14/24/34 and the positive and negative electrodes 131/231/331, 132/232/332. The electrical conduction units 15/25/35 are provided by a conventional method for forming electrically conductive metal on ceramic, such as electroplating, chemical plating, or immersion plating; or by a conventional coupling method that employs an electrically conductive metal wire, such as wire bonding; the present invention has no limitation in this regard. In one embodiment, the electrical conduction units 15 are provided on the surface of the ceramic insulating layer 12. In another embodiment (as shown in FIG. 3 and FIG. 4), the electrical conduction units 25 are provided above the ceramic insulating layer 22. The material electrical conduction units 15/25/35 may be, but is limited to, Cu, Ti, TiW, CuNi, Pd, Au, Ag, AuSn, Sn, and Al.

The following paragraphs describe another preferred embodiment of the present invention.

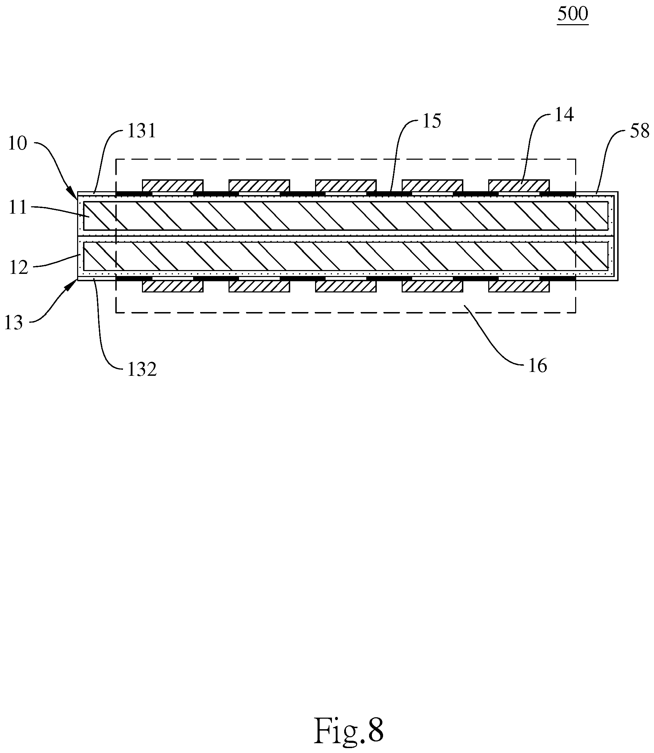

Please refer to FIG. 8 for the flexible LED structure assembly 500 according to an embodiment of the present invention.

This preferred embodiment provides a flexible LED structure assembly that includes a plurality of the foregoing flexible LED structures, wherein the flexible LED structures are tightly attached to each other through the side of each flexible substrate 10 that is not provided with the LED chips 14.

As used herein, the term "tightly attached to each other" refers to adhesive bonding or non-adhesive attachment. Adhesive bonding can be carried out via conventional thermosetting or photocuring adhesive, such as but not limited to phenol-formaldehyde resins, epoxy resins, polyurethane resins, unsaturated polyester resins, acrylic resins, polyolefins/thiols, and vinyl ether resins; or via electrically conductive adhesive, such as but not limited to silver paste, solder, and cast-welding agents. Non-adhesive attachment can be carried out via metal clips for example. In one preferred embodiment, the flexible LED structure assembly 500 includes a metal clip 58 that is provided at one end of the assembly to clamp together the corresponding ends of two flexible LED structures, thereby attaching the structures tightly to each other, and this attachment method provides superior heat dissipation efficiency. The present invention, however, imposes no limitation on how to achieve the state of being "tightly attached to each other.

The present invention is described in more detail below with reference to some illustrative embodiments. It should be understood that the following embodiments serve only to facilitate understanding of the invention and are not intended to be restrictive of the scope of the invention.

### I. First embodiment: flexible LED structure with flip chips

Please refer to FIG. 1 and FIG. 2 respectively for a sectional view and a top view of the first embodiment of the present invention.

To start with, a thin slender strip of aluminum is used as the metal layer 11. The exterior of the metal layer 11 is coated with alumina ceramic to a thickness of 30 µm such that the metal layer 11 is insulated by a ceramic insulating layer 12 covering the exterior of the metal layer 11. The ceramic insulating layer 12-coated metal layer 11 is then provided with a positive electrode 131 at one end and a negative electrode 132 at the opposite end by electroplating. The surface of the ceramic insulating layer 12 is further electroplated to form a layer of metal lines that serve as electrical conduction units 15. The electrical conduction units 15 are electrically connected to the positive electrode 131 and the negative electrode 132. Thus, a flexible substrate 10 is completed.

Next, a plurality of LED chips 14 of flip chips are arranged on the flexible substrate 10. The LED chips 14 are bonded to the flexible substrate 10 by an epoxy resin, and each LED chip 14 is electrically connected to the corresponding electrical conduction units 15. Consequently, the LED chips 14 and the positive and negative electrodes 131, 132 are electrically connected via the electrical conduction units 15 to form a series-connected circuit.

Lastly, four-sided encapsulation is performed by coating the exterior of the flexible substrate 10 with a phosphor layer 16. The phosphor layer 16 completely covers the LED chips 14 and the electrical conduction units 15, exposing only the positive and negative electrodes 131, 132. While the light emitted by the LED chips 14 propagates through the phosphor layer 16, the phosphor powder distributed in the phosphor layer 16 is excited to emit light; as a result, the light of the LED chips 14 is changed, for example, from blue light to white light. The completed flexible LED structure 100 with flip chips can be used as a 360° light source.

### II. Second embodiment: flexible LED structure with horizonal chips

Please refer to FIG. 3 and FIG. 4 respectively for a sectional view and a top view of the second embodiment of the present invention.

To start with, a thin slender strip of aluminum is used as the metal layer 21. The exterior of the metal layer 21 is coated with alumina ceramic to a thickness of 30 µm such that the metal layer 21 is insulated by a ceramic insulating layer 22 covering the exterior of the metal layer 21. The ceramic insulating layer 22-coated metal layer 21 is then provided with a positive electrode 231 at one end and a negative electrode 232 at the opposite end by electroplating to complete a flexible substrate 20.

Next, a plurality of LED chips 24 of horizonal chips are arranged on the flexible substrate 20. The LED chips 24 are bonded to the flexible substrate 20 by silver paste for enhanced thermal conductivity. A metal wire (i.e., an electrical conduction unit 25) is provided, and electrically connected, between each two adjacent LED chips 24 and between each outermost LED chip 24 and the adjacent positive or negative electrode 231, 232 such that the LED chips 24 and the positive and negative electrodes 231, 232 are electrically connected via the electrical conduction units 25 to form a series-connected circuit.

Lastly, four-sided encapsulation is performed by coating the exterior of the flexible substrate 20 with a phosphor layer 26. The phosphor layer 26 completely covers the LED chips 24 and the electrical conduction units 25, exposing only the positive and negative electrodes 231, 232. While the light emitted by the LED chips 24 propagates through the phosphor layer 26, the phosphor powder distributed in the phosphor layer 26 is excited to emit light; as a result, the light of the LED chips 24 is changed, for example, from blue light to white light. The completed flexible LED structure 200 with horizontal chips can be used as a 360° light source.

### III. Third embodiment: flexible LED structure with through holes

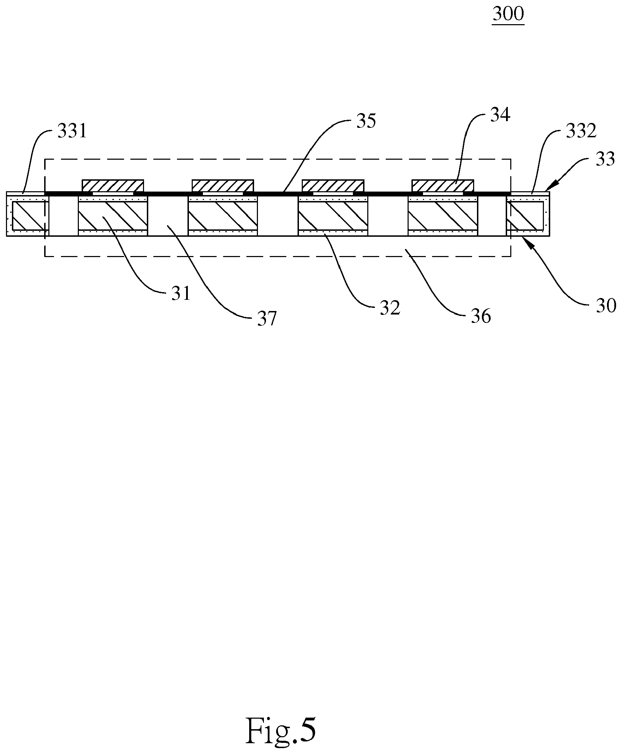

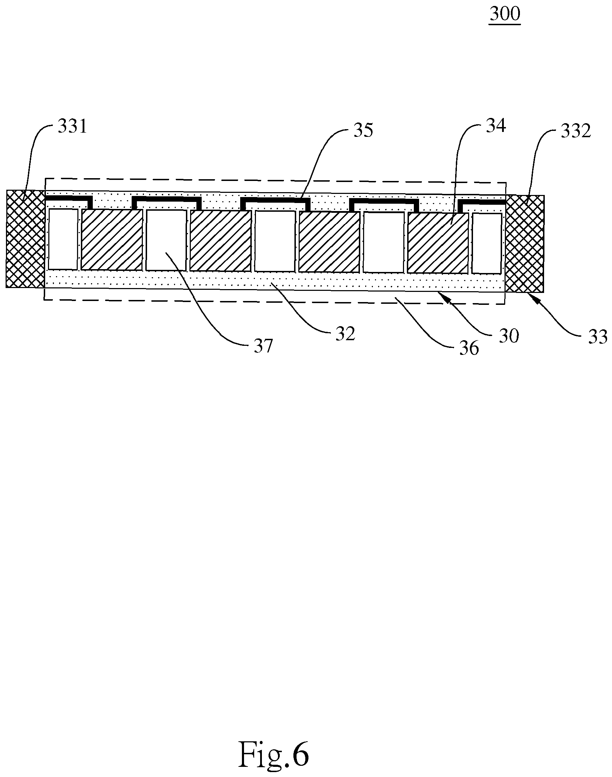

Please refer to FIG. 5 and FIG. 6 respectively for a sectional view and a top view of the third embodiment of the present invention.

To start with, a thin slender strip of aluminum is used as the metal layer 31. The metal layer 31 is bored to form a plurality of through holes 37 in the metal layer 31. Then, the exterior of the metal layer 31 and the inner circumference walls of the through holes 37 are coated with alumina ceramic to a thickness of 30 µm such that the metal layer 31 is insulated by a ceramic insulating layer 32 covering the exterior of the metal layer 31 and the inner circumference walls of the through holes 37. Following that, the ceramic insulating layer 32-coated metal layer 31 is provided with a positive electrode 331 at one end and a negative electrode 332 at the opposite end by electroplating to complete a flexible substrate 30.

Next, a plurality of LED chips 34 of horizonal chips are arranged on the flexible substrate 30 between the through holes 37. A metal wire (i.e., an electrical conduction unit 35) is provided, and electrically connected, between each two adjacent LED chips 34 and between each outermost LED chip 34 and the adjacent positive or negative electrode 331, 332 such that the LED chips 34 and the positive and negative electrodes 331, 332 are electrically connected via the electrical conduction units 35 to form a series-connected circuit.

Lastly, four-sided encapsulation is performed by coating the exterior of the flexible substrate 30 with a phosphor layer 36. The phosphor layer 36 completely covers the LED chips 34 and the electrical conduction units 35, exposing only the positive and negative electrodes 331, 332. While the light emitted by the LED chips 34 propagates through the phosphor layer 36, the phosphor powder distributed in the phosphor layer 36 is excited to emit light; as a result, the light of the LED chips 34 is changed, for example, from blue light to white light. The completed flexible LED structure 300 with through holes can be used as a 360° light source.

The flexible LED structure 300 with through holes is advantageous in that the through holes 37 allow passage of light to increase brightness on the non-die-bonded side.

### IV. Fourth embodiment: flexible LED structure of a folded configuration

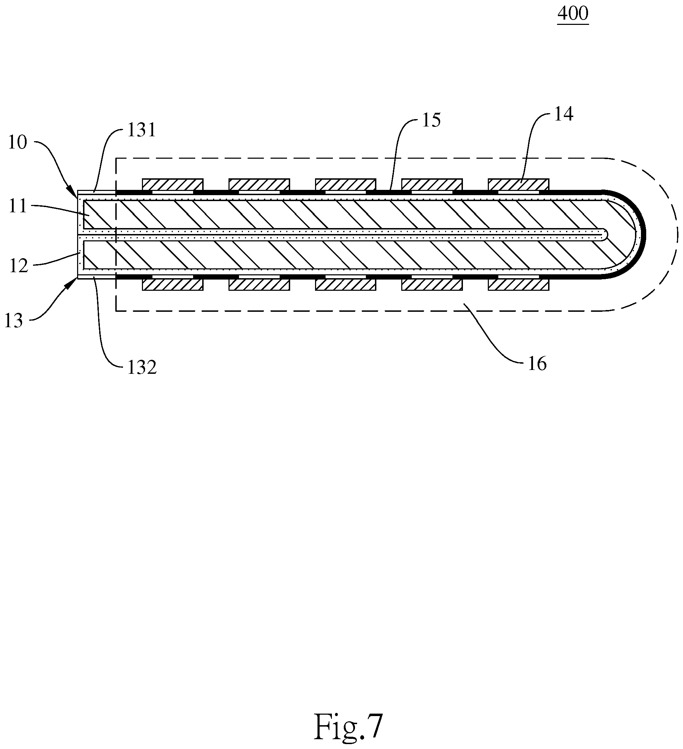

Please refer to FIG. 7 for a sectional view of the fourth embodiment of the present invention.

This embodiment starts with a semi-finished product of the first embodiment, or more particularly with a semi-finished structure that has yet to be coated with the phosphor layer. For the fourth embodiment, the die-bonded side of the semi-finished structure is coated with a phosphor layer 16 such that the phosphor layer 16 completely covers the LED chips 14 and the electrical conduction units 15, exposing only the positive and negative electrodes 131, 132. A flexible LED structure with single-sided encapsulation is thus obtained.

Next, the flexible LED structure with single-sided encapsulation is folded against itself, i.e., bent through 180°, to form a U-shaped structure, with the side of the flexible substrate that is not provided with the LED chips forming the inner side of the U-shaped structure and tightly attached to itself, and the side of the flexible substrate that is provided with the LED chips forming the outer side of the U-shaped structure. The completed flexible LED structure 400 of the foregoing folded configuration can be used as a 360° light source.

The flexible LED structure 400 of a folded configuration is advantageous in that the LED chips are distributed along the exterior of the structure to provide 360° illumination, and that the non-die-bonded side is not encapsulated and therefore helps enhance heat dissipation efficiency.

### Fifth embodiment: flexible LED structure assembly

Please refer to FIG. 8 for a sectional view of the fifth embodiment of the present invention.

This embodiment starts with two semi-finished products of the first embodiment, or more particularly with two semi-finished structures that have yet to be coated with the phosphor layer. For the fifth embodiment, the die-bonded side of each semi-finished structure and the two lateral sides of the die-bonded side of each semi-finished structure are coated with a phosphor layer 16, exposing only the non-die-bonded side and the positive and negative electrodes 131, 132 of each semi-finished structure. The two resulting flexible LED structures, therefore, are each encapsulated on three sides.

Next, the two flexible LED structures with three-sided encapsulation are brought together, with their respective die-bonded sides facing outward. A metal clip 58 is then used at one end of the assembly to secure the corresponding ends of the two structures to each other; as a result, the non-die-bonded sides of the two three-side encapsulated flexible LED structures are tightly attached to each other. The completed flexible LED structure assembly 500 can be used as a 360° light source.

The flexible LED structure assembly 500 has the following advantageous features. First, the LED chips are provided on the exterior of the assembly to provide 360° illumination. Second, highly efficient heat dissipation can be achieved due to the fact that the non-die-bonded sides are not encapsulated, and that the metal clip 58 is the only securing element used in the assembly.

According to the above, the present invention provides a flexible LED structure and an assembly thereof, both of which exhibit rigidity and flexibility and can be bent to adapt to different modes of use or different lamp configurations. Moreover, as the flexible substrate in the invention is composed mainly of metal and ceramic, both of which are relatively low-cost and can dissipate heat efficiently, the invention can solve the heat dissipation problem, and be used to lower the production cost, of the conventional LED lamps. Featuring all-around distribution of light, the various structures disclosed herein not only can be used in LED lightbulbs, but also allow the invention to be applied to a greater variety of lamps and take a wider range of shapes than conventionally allowed in the lighting industry, thereby contributing to the popularization of LED lamps, which are generally recognized as environmentally friendly.

The above is the detailed description of the present invention. However, the above is merely the preferred embodiment of the present invention and cannot be the limitation to the implement scope of the present invention, which means the variation and modification according the present invention may still fall into the scope of the invention.

## Claims

1. A flexible light-emitting diode (LED) structure, comprising:
a flexible substrate composed of a metal layer and a ceramic insulating layer, wherein
the metal layer forms as a core of the flexible substrate and is coated with the ceramic insulating layer, and the flexible substrate is provided with a positive electrode and a negative electrode at one end of the flexible substrate or at two ends of the flexible substrate respectively;
a plurality of LED chips provided on the flexible substrate; and
a plurality of electrical conduction units arranged between the LED chips and electrically connected to the LED chips, the positive electrode, and the negative electrode.

2. The flexible LED structure of claim 1, further including a phosphor layer, wherein the phosphor layer at least partially covers the LED chips and the electrical conduction units on the flexible substrate.

3. The flexible LED structure of claim 2, wherein the metal layer has a plurality of through holes, and each said through hole has an inner circumference wall coated with the ceramic insulating layer.

4. The flexible LED structure of claim 3, wherein the ceramic insulating layer has a thickness of 10 µm∼400 µm.

5. The flexible LED structure of claim 4, wherein the positive electrode and the negative electrode are respectively formed, by a metal plating process, at two ends of a side of the flexible substrate that is provided with the LED chips, and the electrodes are parallel to the LED chips.

6. The flexible LED structure of any one of claims 1 to 4, the LED chips are horizontal chips or flip chips.

7. The flexible LED structure of any one of claims 1 to 4, wherein the flexible LED structure is bent into a U-shaped structure such that: a side of the flexible substrate that is not provided with the LED chips forms an inner side of the U-shaped structure, a side of the flexible substrate that is provided with the LED chips forms an outer side of the U-shaped structure, and the positive electrode and the negative electrode are respectively located at end points of the U-shaped structure.

8. A flexible light-emitting diode (LED) structure assembly, comprising a plurality of said flexible LED structure of any one of claims 1 to 7, wherein the flexible LED structure are tightly attached to each other via sides of the flexible substrates that are not provided with the LED chips.
